# EUROPEAN PATENT APPLICATION

(11) **EP 2 657 977 A1**
(43) Date of publication of application: **30.10.2013**
(21) Application number: 13165448.5
(22) Date of filing: 25.04.2013
(51) Int. Cl.: H01L 31/0216, H01L 31/0224, H01L 31/0693

(54) **Solar cells including low recombination electrical contacts and systems and methods of forming the same**

(30) Priority: 25.04.2012 US 201213456141
(71) Applicant: The Boeing Company, Chicago, IL 60606-2016 (US)
(72) Inventor: Rehder, Eric M., Los Angeles, CA California 90041 (US)
(74) Representative: Howson, Richard G.B.

(57) **Abstract**

Solar cells including low recombination velocity electrical contacts and systems and methods of forming the same. The solar cells include a cell body that defines a front side and an opposed back side. The solar cells further include a front side electrical contact that forms an electrical connection with the front side of the cell body, a back side electrical contact that forms an electrical connection with the back side of the cell body, and at least one intermediate layer that includes an electrically insulating layer and is situated between the cell body and the front side electrical contact and/or the back side electrical contact.

## Description

### FIELD

The present disclosure relates to solar cells, and more particularly to solar cells that include electrical contacts with low mobile carrier recombination velocity electrical contacts.

### BACKGROUND

Solar cells, which also may be referred to herein as photovoltaic cells, are devices that directly convert light, such as sunlight, into an electric current. Solar cells may be formed from a semiconductor material that absorbs photons from sunlight. When the energy of an absorbed photon is greater than the band gap energy of the semiconductor material, the absorption may excite an electron from the valence band of the semiconductor material to the conduction band of the semiconductor material, thereby producing an electron-hole pair, which also may be referred to herein as a free electron and a hole and/or as mobile carriers. The free electron and the hole may move within the solar cell to produce a DC electric current.

The efficiency with which solar cells convert sunlight into electrical energy is governed by a variety of factors, including a proportion of a surface area of the solar cell that is available to absorb the sunlight, an efficiency with which the solar cell generates mobile carriers from the absorbed sunlight, and/or an efficiency with which the generated mobile carriers may be supplied from the solar cell and to an external circuit. Recombination of mobile carriers within the semiconductor material, which may include the combination of a free electron with a hole and the transitioning of the free electron from the conduction band of the semiconductor material to the valence band of the semiconductor material, may decrease the overall efficiency of the solar cell since the recombined mobile carriers are no longer available to be supplied to the external circuit. A rate at which mobile carriers that are generated within the semiconductor materials recombine may be referred to herein as a recombination velocity and/or as a recombination rate.

Mobile carrier recombination velocity may be accelerated at defects and/or incongruities within the semiconductor material, which may act as recombination sites. As an illustrative example, a surface of the semiconductor material, such as may be present at an interface between the semiconductor material and an electrical contact that is configured to form an electrical connection with the semiconductor material, may include a high concentration of recombination sites due to the discontinuous nature of the semiconductor material at the surface, the dangling bonds that may be present at the surface, and/or the change in chemical composition between the semiconductor material and the electrical contact. Decreasing a concentration of and/or eliminating these recombination sites may provide significant increases in solar cell efficiency by decreasing the mobile carrier recombination velocity at and/or near the surface. Thus, there exists a need for improved electrical contacts for solar cell applications.

### SUMMARY

Solar cells including low recombination velocity electrical contacts and systems and methods of forming the same. The solar cells include a cell body that defines a front side and an opposed back side. The solar cells further include a front side electrical contact that forms an electrical connection with the front side of the cell body, a back side electrical contact that forms an electrical connection with the back side of the cell body, and at least one intermediate layer that includes an electrically insulating layer and is situated between the cell body and the front side electrical contact and/or the back side electrical contact.

According to an aspect of the present disclosure is provided a solar cell comprising: a cell body that defines a front side and an opposed back side, wherein the cell body includes an emitter layer that includes one of an n-type III-V semiconductor material and a p-type III-V semiconductor material, wherein the cell body further includes a base layer that includes the other of the n-type III-V semiconductor material and the p-type III-V semiconductor material, and further wherein the base layer is situated between the emitter layer and the back side of the cell body; a front side electrical contact that forms an electrical connection with the front side of the cell body, wherein the front side electrical contact includes an optically transparent front side electrode and a metallic front side electrode; a front side intermediate layer that includes a front side electrically insulating layer and is situated between the front side of the cell body and the front side electrical contact; a back side electrical contact that forms an electrical connection with the back side of the cell body, wherein the back side electrical contact includes a metallic back side electrode; and a back side intermediate layer that includes a back side electrically insulating layer and is situated between the back side of the cell body and the back side electrical contact.

According to an aspect of the present disclosure there is provided that the intermediate layer includes a deposited electrically insulating layer. In some embodiments, the intermediate layer includes a native oxide layer and/or a grown oxide layer. In some embodiments, the intermediate layer further includes a surface passivation layer. In some embodiments, the electrically insulating layer and the surface passivation layer define parallel layers, wherein the surface passivation layer is situated between the cell body and the electrically insulating layer.

According to another aspect of the present disclosure there is provided a solar cell comprising: a cell body that defines a front side and an opposed back side, wherein the cell body is formed from a semiconductor material; a front side electrical contact that forms an electrical connection with the front side of the cell body; a back side electrical contact that forms an electrical connection with the back side of the cell body; and an intermediate layer that is situated between the cell body and at least one of the front side electrical contact and the back side electrical contact, wherein the intermediate layer includes an electrically insulating layer, and further wherein the electrically insulating layer includes a deposited electrically insulating layer.

Advantageously the cell body includes an emitter layer that includes one of an n-type III-V semiconductor material and a p-type III-V semiconductor material, wherein the cell body further includes a base layer that includes the other of the n-type III-V semiconductor material and the p-type III-V semiconductor material, and further wherein the base layer is situated between the emitter layer and the back side of the cell body.

Advantageously the solar cell further includes an emitter layer, wherein the emitter layer forms a portion of the front side electrical contact, and further wherein the cell body further includes a base layer.

Advantageously the electrically insulating layer includes at least one of an oxide, aluminum oxide, silicon nitride, silicon oxide, silicon dioxide, zinc sulfide, hafnium oxide, and silicon oxynitride.

Preferably the electrically insulating layer has a thickness of at least 1 nm and less than 6 nm.

Advantageously the intermediate layer further includes a surface passivation layer that is configured to reduce a mobile carrier recombination velocity at a surface of the cell body.

Advantageously the surface passivation layer has a thickness of less than 2 nm.

Advantageously the surface passivation layer and the electrically insulating layer define parallel layers, and further wherein the surface passivation layer is situated between the cell body and the electrically insulating layer.

Advantageously the intermediate layer is a front side intermediate layer that is situated between the cell body and the front side electrical contact.

Advantageously the intermediate layer is a back side intermediate layer that is situated between the cell body and the back side electrical contact.

Advantageously the solar cell includes a plurality of intermediate layers including a front side intermediate layer that is situated between the cell body and the front side electrical contact and a back side intermediate layer that is situated between the cell body and the back side electrical contact.

Advantageously the front side electrical contact is deposited on and is in electrical communication with at least one of the front side of the cell body and the intermediate layer.

Preferably the front side electrical contact includes a metallic front side electrode. Preferably the front side electrical contact includes an optically transparent front side electrode.

Advantageously the back side electrical contact is deposited on and is in electrical communication with at least one of the back side of the cell body and the intermediate layer. Preferably the back side electrical contact includes a metallic back side electrode. Alternatively the back side electrical contact includes an optically transparent back side electrode.

Advantageously at least one of the front side electrical contact and the back side electrical contact includes a metallic electrode and an optically transparent electrode, and further wherein the optically transparent electrode is situated between the metallic electrode and the cell body.

Advantageously the front side of the cell body is a light-incident side of the cell body.

In some embodiments the front side electrical contact includes a metallic front side electrode and/or an optically transparent front side electrode. In some embodiments, the back side electrical contact includes a metallic back side electrode and/or an optically transparent back side electrode. In some embodiments, the cell body includes an emitter layer that is formed from a semiconductor material of a first conductivity type and a base layer that is formed from a semiconductor material of a second conductivity type. In some embodiments, the front side electrical contact defines the emitter layer and the cell body includes the base layer.

According to a further aspect of the present disclosure there is provided, a solar cell comprising: a cell body that defines a front side and an opposed back side, wherein the cell body includes an emitter layer that includes one of an n-type III-V semiconductor material and a p-type III-V semiconductor material, wherein the cell body further includes a base layer that includes the other of the n-type III-V semiconductor material and the p-type III-V semiconductor material, and further wherein the base layer is situated between the emitter layer and the back side of the cell body; a front side electrical contact that forms an electrical connection with the front side of the cell body; a back side electrical contact that forms an electrical connection with the back side of the cell body; and an intermediate layer that is situated between the cell body and at least one of the front side electrical contact and the back side electrical contact, wherein the intermediate layer includes an electrically insulating layer.

Advantageously the electrically insulating layer includes a deposited electrically insulating layer.

Advantageously the electrically insulating layer includes at least one of an oxide, aluminum oxide, silicon nitride, silicon oxide, silicon dioxide, zinc sulfide, hafnium oxide, and silicon oxynitride.

Advantageously the electrically insulating layer includes at least one of a native oxide layer and a grown oxide layer.

Advantageously the electrically insulating layer has a thickness of at least 1 nm and less than 6 nm.

### BRIEF DESCRIPTION OF THE DRAWINGS

Fig. 1 is a schematic representation of illustrative, non-exclusive examples of a solar cell that includes an intermediate layer according to the present disclosure.
Fig. 2 provides less schematic but still illustrative, non-exclusive examples of a portion of the solar cell of Fig. 1, including an interface that includes an intermediate layer according to the present disclosure and is between a front side electrical contact and a cell body.
Fig. 3 provides additional less schematic but still illustrative, non-exclusive examples of a portion of the solar cell of Fig. 1, including an interface that includes an intermediate layer according to the present disclosure and is between a front side electrical contact and a cell body.
Fig. 4 provides less schematic but still illustrative, non-exclusive examples of a portion of the solar cell of Fig. 1, including an interface that includes an intermediate layer according to the present disclosure and is between a cell body and a back side electrical contact.

### DESCRIPTION

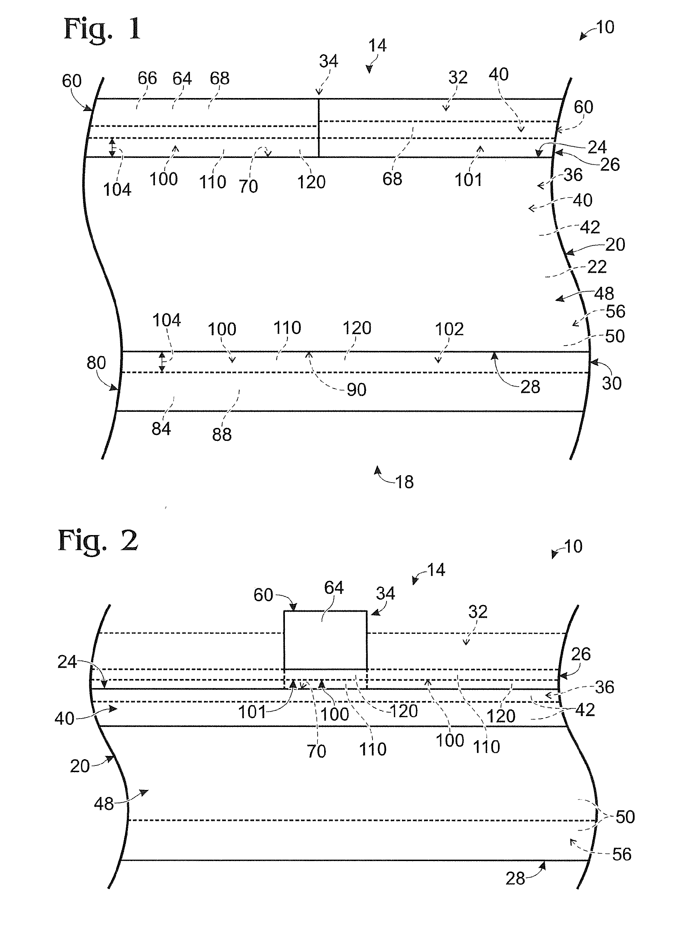

Figs. 1-4 provide illustrative, non-exclusive examples of solar cells 10, and/or portions thereof, according to the present disclosure. Elements that serve a similar, or at least substantially similar, purpose are labeled with like numbers in each of Figs. 1-4, and these elements may not be discussed in detail herein with reference to each of Figs. 1-4. Similarly, all elements may not be labeled in each of Figs. 1-4, but reference numerals associated therewith may still be utilized herein for consistency. In general, elements that are likely to be included in a given embodiment are shown in solid lines, while elements that are optional to a given embodiment are shown in dashed lines. However, elements that are shown in sold lines are not essential to all embodiments, and it is within the scope of the present disclosure that an element shown in solid lines may be omitted from a particular embodiment.

Fig. 1 is a schematic representation of illustrative, non-exclusive examples of a solar cell 10 according to the present disclosure. Solar cell 10 includes a front side 14, which also may be referred to herein as a light-incident side 14, that is configured to receive light, such as sunlight and/or another form of electromagnetic radiation, for absorption there into, as well as a back side 18, which also may be referred to herein as a light-opposed side 18, that is opposite, or opposed, to front side 14. Solar cell 10 further includes a cell body 20 that includes a front side 24 and an opposed back side 28, a front side electrical contact 60 that forms an electrical connection with front side 24, a back side electrical contact 80 that forms an electrical connection with back side 28, and at least one intermediate layer 100, such as front side intermediate layer 101 and/or back side intermediate layer 102, that is situated between front side electrical contact 60 and cell body 20 and/or back side electrical contact 80 and cell body 20.

Intermediate layer 100 may include any suitable structure that is configured to improve the electrical connection between front side electrical contact 60 and front side 24 and/or to improve the electrical connection between back side electrical contact 80 and back side 28. This may include structures that provide a low resistance electrical connection, as well as structures that decrease the mobile carrier recombination velocity at an interface 26 between front side electrical contact 60 and front side 24 and/or that decrease the mobile carrier recombination velocity at an interface 30 between back side electrical contact 80 and back side 28. Illustrative, non-exclusive examples of intermediate layers 100 according to the present disclosure are discussed in more detail herein.

It is within the scope of the present disclosure that intermediate layer 100 may include and/or define any suitable shape. As an illustrative, non-exclusive example, intermediate layer 100 may include and/or be an at least substantially planar, or planar, intermediate layer 100.

Intermediate layer 100 also may include any suitable chemical composition and/or may possess any suitable mechanical, electrical, and/or chemical properties. As an illustrative, non-exclusive example, and as shown in Fig. 1, intermediate layer 100 may include and/or be an electrically insulating layer 110. Illustrative, non-exclusive examples of electrically insulating layers 110 according to the present disclosure include deposited insulating layers, deposited oxide layers, native oxide layers, grown oxide layers, an aluminum oxide layer, a silicon nitride layer, a silicon oxide layer, a silicon dioxide layer, a zinc sulfide layer, a hafnium oxide layer, and/or a silicon oxynitride layer. Generally, electrically insulating materials may be utilized to stop, block, and/or otherwise slow a flow of electric current there through. However, if the electrically insulating material is formed as a thin layer, there exists a finite possibility that electrons that are present on a first side of the thin layer may tunnel through the thin layer to a second side of the thin layer, providing for a flow of electric current thereacross. This tunneling probability increases as a thickness of the thin layer is decreased.

Thus, and while they may be constructed from materials that behave as insulators while in the bulk state, electrically insulating layers 110 according to the present disclosure may provide for a flow of electric current there across. In addition, and in the case of solar cells 10 according to the present disclosure, the presence of electrically insulating layer 110 between cell body 20 and front side electrical contact 60 and/or back side electrical contact 80 may decrease the mobile carrier recombination velocity at the interface between cell body 20 and front side electrical contact 60 and/or back side electrical contact 80, thereby increasing the efficiency of solar cell 10.

Electrically insulating layer 110 may include and/or define any suitable thickness 104. As illustrative, non-exclusive examples, the electrically insulating layer may include a thickness of at least 0.1 nanometers (nm), at least 0.2 nm, at least 0.25 nm, at least 0.3 nm, at least 0.4 nm, at least 0.5 nm, at least 0.6 nm, at least 0.7 nm, at least 0.75 nm, at least 0.8 nm, at least 0.9 nm, at least 1 nm, at least 1.1 nm, at least 1.2 nm, at least 1.25 nm, at least 1.3 nm, at least 1.4 nm, at least 1.5 nm, at least 1.6 nm, at least 1.7 nm, at least 1.75 nm, at least 1.8 nm, at least 1.9 nm, at least 2 nm, at least 2.25 nm, at least 2.5 nm, at least 3 nm, at least 3.5 nm, at least 4 nm, at least 4.5 nm, at least 5 nm, or at least 5.5 nm. Additionally or alternatively, the electrically insulating layer also may include a thickness of less than 15 nm, less than 14 nm, less than 13 nm, less than 12 nm, less than 11 nm, less than 10 nm, less than 9 nm, less than 8 nm, less than 7.5 nm, less than 7 nm, less than 6.5 nm, less than 6 nm, less than 5.5 nm, less than 5 nm, less than 4.5 nm, less than 4 nm, less than 3.5 nm, or less than 3 nm.

In general, electrically insulating layers 110 will include a relatively high bulk electrical resistivity. Illustrative, non-exclusive examples of the bulk electrical resistivity of electrically insulating layers 110 according to the present disclosure include bulk electrical resistivities of greater than 10⁴ Ohm*cm, greater than 10⁵ Ohm*cm, greater than 10⁶ Ohm*cm, greater than 10⁷ Ohm*cm, greater than 10⁸ Ohm*cm, greater than 10⁹ Ohm*cm, greater than 10¹⁰ Ohm*cm, greater than 10¹¹ Ohm*cm, greater than 10¹² Ohm*cm, greater than 10¹³ Ohm*cm, greater than 10¹⁴ Ohm*cm, greater than 10¹⁵ Ohm*cm, greater than 10¹⁶ Ohm*cm, greater than 10¹⁷ Ohm*cm, or greater than 10¹⁸ Ohm*cm.

As discussed in more detail herein, it is within the scope of the present disclosure that electrically insulating layer 110 may include a planar, or at least substantially planar, electrically insulating layer that may be coextensive with all, or at least substantially all, of front side 24 and/or back side 28 of cell body 20. Additionally or alternatively, it is also within the scope of the present disclosure that electrically insulating layer 110 is only present on a portion of front side 24 and/or back side 28, such as on a portion that is covered by and/or in contact with front side electrical contact 60 and/or back side electrical contact 80.

As another illustrative, non-exclusive example, and as also shown in Fig. 1, intermediate layer 100 also may include and/or be a surface passivation layer 120. Surface passivation layer 120 may include any suitable structure that is configured to reduce the mobile carrier recombination velocity at and/or near front side 24 and/or back side 28 of cell body 20. As an illustrative, non-exclusive example, surface passivation layer 120 may be configured to reduce a concentration of broken bonds and/or recombination sites on and/or proximal to front side 24 and/or back side 28. As another illustrative, non-exclusive example, surface passivation layer 120 may include and/or be a surface of the cell body 20, such as front side 24 and/or back side 28, that has received a surface passivation treatment. As yet another illustrative, on-exclusive example, surface passivation layer 120 may include and/or be a dielectric layer.

Surface passivation layer 120 may extend across any suitable portion of front side 24 and/or back side 28. As an illustrative, non-exclusive example, surface passivation layer 120 may include and/or be a planar, or at least substantially planar, surface passivation layer and/or may be coextensive with all, or at least substantially all, of front side 24 and/or back side 28.

It is within the scope of the present disclosure that surface passivation layer 120 may include and/or define any suitable thickness 104. As illustrative, non-exclusive examples, thickness 104 of surface passivation layer 120 may be less than 5 nm, less than 4 nm, less than 3 nm, less than 2 nm, less than 1 nm, less than 0.8 nm, less than 0.6 nm, less than 0.5 nm, less than 0.4 nm, less than 0.3 nm, less than 0.2 nm, or less than 0.1 nm.

As yet another illustrative, non-exclusive example, intermediate layer 100 also may include and/or be both electrically insulating layer 110 and surface passivation layer 120. When intermediate layer 100 includes both electrical insulating layer 110 and surface passivation layer 120, the layers may define parallel layers, planar layers, and/or substantially planar layers and may be oriented relative to one another in any suitable manner. As an illustrative, non-exclusive example, surface passivation layer 120 may be situated between cell body 20 and electrically insulating layer 110. When intermediate layer 100 includes both electrically insulating layer 110 and surface passivation layer 120, thickness 104 may include and/or be a total thiFFckness 104 of intermediate layer 100, such as may be defined as a sum of the thickness of electrically insulating layer 110 and the thickness of surface passivation layer 120.

Front side electrical contact 60 may include any suitable structure that is configured to form the electrical connection with front side 24 of cell body 20 and may form the electrical connection in any suitable manner. As an illustrative, non-exclusive example, front side electrical contact 60 may include a metallic front side electrode 64 and/or an optically transparent front side electrode 68. As another illustrative, non-exclusive example, front side electrical contact 60 may be placed into electrical communication with, formed on, formed from, and/or deposited on front side 24 of cell body 20.

Metallic front side electrode 64 may not be transparent to light that is incident thereupon, may reflect light that is incident thereupon away from solar cell 10, and/or may absorb light that is incident thereupon. As such, solar cell 10 may be designed such that metallic front side electrode 64 covers only a portion of front side 24 of cell body 20, and metallic front side electrode 64 also may be referred to herein as including a plurality of metallic lines 66. This is shown schematically in dashed lines in Fig. 1, wherein metallic front side electrode 64 is only present on the left side of solar cell 10. Illustrative, non-exclusive examples of metallic front side electrodes 64 according to the present disclosure include nickel germanium gold, palladium germanium gold, copper, and/or aluminum metallic front side electrodes 64.

Additionally, and when solar cell 10 includes metallic front side electrode 64, a front side cap layer 70 may be situated between metallic front side electrode 64 and cell body 20 and/or between front side 24 of cell body 20 and front side intermediate layer 101, when present. Front side cap layer 70 may be configured to act as a barrier to diffusion between metallic front side electrode 64 and cell body 20 and/or may decrease diffusion there between.

Optically transparent front side electrode 68 may be configured to be transparent, or at least substantially transparent, to the light that is absorbed by cell body 20 to produce mobile carriers within the cell body. This may include optically transparent front side electrodes 68 that are transparent to at least 50%, at least 60%, at least 70%, at least 80%, at least 90%, at least 95%, at least 97.5%, at least 99%, or at least 99.9% of the light that is incident upon cell body 20 that is within a range of wavelengths such that it may be absorbed by cell body 20 to produce the mobile carriers.

Optically transparent front side electrode 68 may include any suitable structure and/or composition. Illustrative, non-exclusive examples of optically transparent front side electrodes 68 according to the present disclosure include any suitable optically transparent front side electrode 68 that may be formed of any suitable material, illustrative, non-exclusive examples of which include indium tin oxide, zinc oxide, tin oxide, zinc selenide, graphene, carbon nanotubes, gallium nitride, and/or diamond.

Since optically transparent front side electrode 68 is at least partially transparent to light that is incident thereupon, optically transparent front side electrode 68 may cover a majority and/or all of front side 24 of cell body 20. This is shown in dashed lines in Fig. 1.

Front side electrical contact 60 also may include both metallic front side electrode 64 and optically transparent front side electrode 68. When front side electrical contact 60 includes both metallic front side electrode 64 and optically transparent front side electrode 68, optically transparent front side electrode 68 may be situated between and electrically separate metallic front side electrode 64 and cell body 20. The combination of metallic front side electrode 64 with optically transparent front side electrode 68 may improve conduction of mobile carriers from front side 24 of cell body 20 to front side electrical contact 60 by increasing a proportion of front side 24 that is in contact with, proximal to, and/or covered by front side electrical contact 60. This may provide for increasing a spacing between the plurality of metallic lines 66 that are included in metallic front side electrode 64 relative to a front side electrical contact 60 that includes metallic front side electrode 64 but does not include optically transparent front side electrode 68. This increase in spacing may increase a proportion of front side 24 that may be available to absorb light that is incident thereupon and/or decrease reflection and/or absorption of light by metallic front side electrical contact 64.

Back side electrical contact 80 may include and/or be a metallic back side electrode 84 and/or an optically transparent back side electrode 88. In addition, a back side cap layer 90 may be present between metallic back side electrode 84 and cell body 20 and/or between back side 28 of cell body 20 and back side intermediate layer 102, when present, to decrease diffusion there between. The materials and/or construction of back side electrical contact 80, metallic back side electrode 84, optically transparent back side electrode 88, back side cap layer 90, and/or combinations thereof, may be substantially similar to that of front side electrical contact 60, metallic front side electrode 64, optically transparent front side electrode 68, and/or front side cap layer 70, respectively, and are discussed in more detail herein with reference to front side electrical contact 60.

In addition to the configurations that are discussed with reference to front side electrical contact 60, and because back side electrical contact 80 need not be transparent to light that is incident thereupon, back side electrical contact 80 also may include a metallic back side electrode 84 that covers a majority and/or all of back side 24 of cell body 20. Thus, and when back side electrical contact 80 includes both metallic back side electrode 84 and optically transparent back side electrode 88, the two electrodes may define parallel and/or substantially planar layers, with optically transparent back side electrode 88 being situated between cell body 20 and metallic back side electrode 84.

The use of a metallic back side electrode 84 that covers a majority or all of back side 28 of cell body 20 may provide a highly reflective interface 30 between cell body 20 and back side electrical contact 80 and/or between intermediate layer 100 and back side electrical contact 80. Highly reflective interface 30 may reflect light that travels through cell body 20 to interface 30 back into cell body 20, thereby increasing a probability for generation of mobile carriers due to absorption of photons from the light and increasing the overall efficiency of the solar cell.

Cell body 20 may include any suitable structure that is configured to absorb light that is incident thereupon, to produce mobile carriers there from, and/or to provide the produced mobile carriers to front side electrical contact 60 and/or back side electrical contact 80. As an illustrative, non-exclusive example, cell body 20 may include and/or be a substantially planar cell body 20 that defines front side 24 and back side 28. As another illustrative, non-exclusive example, cell body 20 may include, be formed from, and/or be formed on a semiconductor material 22, illustrative, non-exclusive examples of which include a III-V semiconductor material, gallium arsenide, aluminum gallium arsenide, indium gallium phosphide, indium gallium arsenide nitride, indium phosphide, indium gallium arsenide, germanium, and/or silicon.

When cell body 20 includes semiconductor material 22, it is within the scope of the present disclosure that a first portion of cell body 20 may include a first conductivity type 42, while a second portion of cell body 20 may include a second conductivity type 50 that is different from the first conductivity type. Illustrative, non-exclusive examples of the first conductivity type and the second conductivity type include n-type and p-type. As an illustrative, non-exclusive example, the first portion of cell body 20 may include an n-type semiconductor material, where free electrons form a majority of the mobile carriers that are present therein, while the second portion of cell body 20 may include a p-type semiconductor material, where holes form a majority of the mobile carriers that are present therein. As another illustrative, non-exclusive example, the first portion of cell body 20 may include a p-type semiconductor material, while the second portion of cell body 20 may include an n-type semiconductor material.

Cell body 20 may include a plurality of layers, which also may be referred to herein as regions and/or portions of cell body 20. These layers may include a window layer 36, an emitter layer 40, a base layer 48, and/or a back surface field layer 56.

Window layer 36, when present, may be situated on and/or form front side 24 of cell body 20, may be situated between front side electrical contact 60 and emitter layer 40 and/or base layer 48, may be situated between an antireflective layer 32, which is discussed in more detail herein, and emitter layer 40 and/or base layer 48, and/or may be situated between front side intermediate layer 101 and emitter layer 40 and/or base layer 48. Additionally or alternatively, front side intermediate layer 101 may be situated between front side electrical contact 60 and window layer 36.

Window layer 36 may be configured and/or designed to reduce the mobile carrier recombination velocity within cell body 20 and/or at interface 26 between cell body 20 and front side electrical contact 60 and may include any suitable material that may be at least substantially transparent to a range of wavelengths of incident light that may be absorbed by a remainder of the cell body to produce the mobile carriers. As an illustrative, non-exclusive example, the window layer may include a wide bandgap semiconductor material and/or a semiconductor material of first conductivity type 42.

Window layer 36 may include any suitable thickness. Thicker window layers 36 typically produce lower recombination velocities for mobile carriers therein but also decrease a proportion of the light that is incident on front side 24 of cell body 20 that penetrates the window layer to produce the mobile carriers within the remainder of cell body 20. Thus, there exists a solar cell performance, or efficiency, tradeoff with regard to window layer construction.

When used in conjunction with front side intermediate layer 101, which may substantially reduce the mobile carrier recombination velocity, it is within the scope of the present disclosure that solar cell 10 may utilize a thinner window layer 36 than a window layer 36 that may be utilized in a comparable solar cell 10 that includes window layer 36 but does not include front side intermediate layer 101. Alternatively, it is also within the scope of the present disclosure that solar cell 10 may not include window layer 36. When present, illustrative, non-exclusive examples of window layer 36 thicknesses according to the present disclosure include window layer 36 thicknesses of less than 500 Angstroms (Å), less than 450 Å, less than 400 Å, less than 350 Å, less than 300 Å, less than 250 Å, less than 200 Å, less than 150 Å, less than 100 Å, less than 75 Å, less than 50 Å, or less than 25 Å, as well as window layer thicknesses greater than 10 Å, greater than 20 Å, greater than 30 Å, greater than 40 Å, greater than 50 Å, greater than 75 Å, greater than 100 Å, greater than 125 Å, greater than 150 Å, greater than 175 Å, or greater than 200Å.

Solar cells 10 according to the present disclosure include an emitter layer 40 that may be present within cell body 20 and/or may form a portion of front side electrical contact 60. When emitter layer 40 forms a portion of cell body 20, the emitter layer 40 may include a semiconductor material of first conductivity type 42. Alternatively, and when emitter layer 40 forms a portion of front side electrical contact 60, the emitter layer 40 may include any of the materials that are discussed in more detail herein with reference to optically transparent front side electrode 68.

When emitter layer 40 forms a portion of cell body 20, emitter layer 40 may be situated between window layer 36 and base layer 48, between front side intermediate layer 101 and base layer 48, between front side electrical contact 60 and base layer 48, and/or between antireflective layer 32 and base layer 48. Additionally or alternatively, front side intermediate layer 101 may be situated between front side electrical contact 60 and emitter layer 40 and/or between antireflective layer 32 and emitter layer 40.

When emitter layer 40 forms a portion of front side electrical contact 60, emitter layer 40 may be included in and/or be optically transparent front side electrode 68. In addition, intermediate layer 100 may be located between emitter layer 40 and base layer 48 and/or between emitter layer 40 and cell body 20.

Base layer 48 may include a semiconductor material of second conductivity type 50 and/or may comprise a majority of a thickness of cell body 20. Base layer 48 may be situated between emitter layer 40 and back surface field layer 56, between emitter layer 40 and back side electrical contact 80, between front side electrical contact 60 and back surface field layer 56, and/or between front side electrical contact 60 and back side electrical contact 80. Additionally or alternatively, front side intermediate layer 101 may be situated between base layer 48 and front side electrical contact 60 and/or back side intermediate layer 102 may be situated between base layer 48 and back side electrical contact 80.

It is within the scope of the present disclosure that cell body 20 may include one or more polished and/or textured sides, such as front side 24 and/or back side 28. When cell body 20 includes a polished surface, a root mean square roughness of the polished surface may be less than 100 nanometers (nm), less than 75 nm, less than 50 nm, less than 40 nm, less than 30 nm, less than 20 nm, less than 10 nm, less than 5 nm, less than 4 nm, less than 3 nm, less than 2 nm, or less than 1 nm. Additionally or alternatively, and when cell body 20 includes a textured surface, the root mean square roughness of the textured surface may be at least 0.1 micrometer (um), at least 0.2 um, at least 0.3 um, at least 0.4 um, at least 0.5 um, at least 0.75 um, at least 1 um, at least 1.25 um, at least 1.5 um, or at least 2 um. Additionally or alternatively, the root mean square roughness of the textured surface also may be less than 3 um, less than 2.5 um, less than 2 um, less than 1.5 um, less than 1.25 um, or less than 1 um.

Back surface field layer 56, when present, may include a semiconductor material of second conductivity type 50, may include a mobile carrier, or dopant, concentration that is higher than a mobile carrier, or dopant, concentration within base layer 48, and/or may be configured to reduce mobile carrier recombination within solar cell 10. Back surface field layer 56 may be situated between base layer 48 and back side electrical contact 80 and/or between base layer 48 and back side intermediate layer 102. Additionally or alternatively, back side intermediate layer 102 may be situated between back surface field layer 56 and back side electrical contact 80.

Antireflective layer 32 may include any suitable structure that is configured to decrease reflection of light from and/or increase absorption of light within cell body 20. Illustrative, non-exclusive examples of antireflective layers 32 according to the present disclosure include thin film antireflective layers, planar antireflective layers, substantially planar antireflective layers, and/or dielectric antireflective layers.

Antireflective layer 32 may cover any suitable portion, which also may be referred to herein as a fraction, of front side 24 of cell body 20 and/or front side 14 of solar cell 10. As an illustrative, non-exclusive example, and as shown in Fig. 1, antireflective layer 32 may cover a portion of front side 24 that does not include metallic front side electrode 64 and/or a portion of front side 24 that is configured to transmit incident light there through for absorption within cell body 20. As another illustrative, non-exclusive example, antireflective layer 32 may define at least a portion of front side 14 and/or at least a portion of an exposed front side of solar cell 10 and/or front side electrical contact 60. As yet another illustrative, non-exclusive example, antireflective layer 32 may include and/or defme a plurality of openings 34 therein that are configured to provide for the electrical connection between front side electrical contact 60 and cell body 20.

Fig. 2 provides less schematic but still illustrative, non-exclusive examples of a portion of solar cell 10 of Fig. 1, including interface 26 that includes front side intermediate layer 101 between front side electrical contact 60 and a cell body 20. In Fig. 2, front side electrical contact 60 includes metallic front side electrode 64 and may include front side cap layer 70 between front side intermediate layer 101 and front side 24 of cell body 20. When solar cell 10 includes front side cap layer 70, front side cap layer 70 may only be present on a portion of front side 24 that is opposed to metallic front side electrode 64. Antireflective layer 32 may cover a portion of front side 24 of cell body 20 that does not include metallic front side electrode 64 and may include a plurality of openings 34 that may provide for the electrical connection between metallic front side electrode 64 and intermediate layer 100 and/or cell body 20.

In Fig. 2, front side intermediate layer 101 includes electrically insulating layer 110 and/or surface passivation layer 120. When front side intermediate layer 101 includes both electrically insulating layer 110 and surface passivation layer 120, the layers may form substantially parallel layers, with surface passivation layer 120 separating electrically insulating layer 110 from cell body 20. As shown in Fig. 2, front side intermediate layer 101 and/or electrically insulating layer 110 and/or surface passivation layer 120 thereof are present at least between metallic front side electrode 64 and cell body 20 and may be present on substantially all, or all, of front surface 24, thereby separating antireflective layer 32, when present, from cell body 20.

Cell body 20 of Fig. 2 may include window layer 36 and includes emitter layer 40, which may be formed from a semiconductor material of first conductivity type 42. Cell body 20 also includes base layer 48 and may include back surface field layer 56, which may be formed from a semiconductor material of second conductivity type 50. However, it is within the scope of the present disclosure that cell body 20 may not include window layer 36 and/or back surface field layer 56.

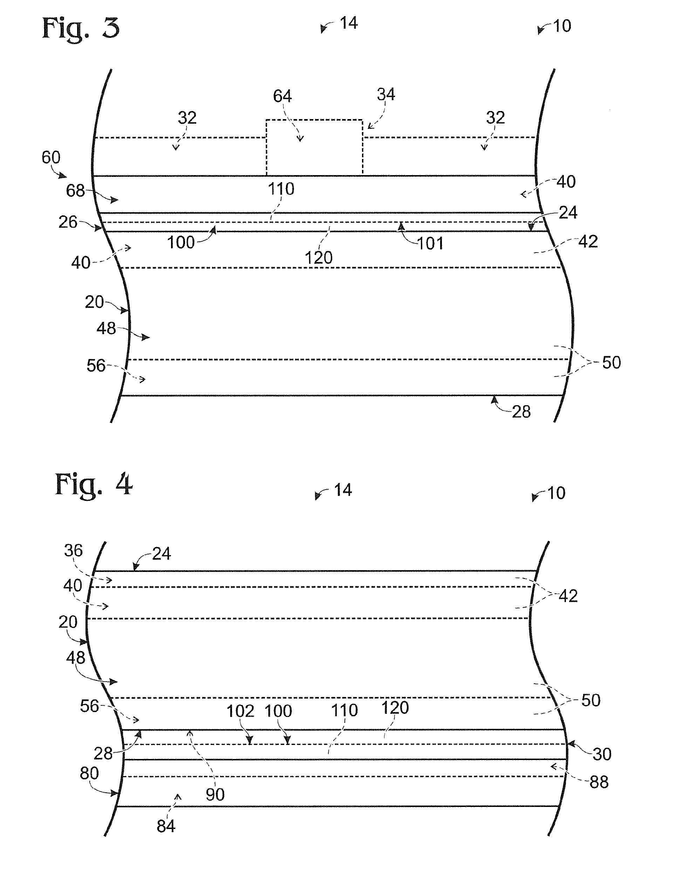

Fig. 3 provides additional less schematic but still illustrative, non-exclusive examples of a portion of the solar cell 10 of Fig. 1, including interface 26 that includes front side intermediate layer 101 between a front side electrical contact 60 and a cell body 20. In Fig. 3, front side electrical contact 60 includes optically transparent front side electrode 68. Front side electrical contact 60 also may include metallic front side electrode 64, which may extend through openings 34 in antireflective layer 32, and may be in electrical communication with optically transparent front side electrode 68.

Front side intermediate layer 101 and may include electrically insulating layer 110 and/or surface passivation layer 120. When front side intermediate layer 101 includes both electrically insulating layer 110 and surface passivation layer 120, the layers may form substantially parallel layers, with surface passivation layer 120 separating electrically insulating layer 110 from cell body 20.

As discussed in more detail herein, emitter layer 40 may be defined by optically transparent front side electrode 68 and/or may form a portion of cell body 20. When emitter layer 40 forms a portion of cell body 20, it may be present between front side intermediate layer 101 and base layer 48 and may be constructed from a semiconductor material of first conductivity type 42. Cell body 20 further includes base layer 48 and also may include back surface field layer 56, both of which may be constructed from a semiconductor material of second conductivity type 50.

Fig. 4 provides less schematic but still illustrative, non-exclusive examples of a portion of the solar cell 10 of Fig. 1, including interface 30 that includes back side intermediate layer 102 between a cell body 20 and a back side electrical contact 80. Cell body 20 may be substantially similar to cell body 20 of Figs. 2-3 and is discussed in more detail herein with reference thereto.

Back side intermediate layer 102 may be situated between cell body 20 and back side electrical contact 80 and may include electrically insulating layer 110 and/or surface passivation layer 120. When back side intermediate layer 102 includes both electrically insulating layer 110 and surface passivation layer 120, the layers may form substantially parallel layers, with surface passivation layer 120 separating electrically insulating layer 110 from cell body 20.

Back side electrical contact 80 may include any suitable structure that is configured to form the electrical connection with cell body 20. As an illustrative, non-exclusive example, back side electrical contact 80 may include a metallic back side electrode 84 and/or an optically transparent back side electrode 88. As discussed in more detail herein, back side electrical contact 80 may cover substantially all and/or all of back side 28 of cell body 20 and a back side cap layer 90 may decrease a potential for diffusion between cell body 20 and back side electrical contact 80. In addition, and as also discussed in more detail herein, when back side electrical contact 80 includes both metallic back side electrode 84 and optically transparent back side electrode 88, optically transparent back side electrode 88 may be situated between metallic back side electrode 84 and intermediate layer 100.

While Figs. 2-4 illustrate a single cell body 20 separating front side electrical contact 60 from back side electrical contact 80, it is within the scope of the present disclosure that solar cell 10 may include a plurality of cell bodies 20 including at least a front side cell body and a back side cell body, with the plurality of cell bodies 20 being arranged on top of and in electrical communication with one another in a plurality of at least substantially coextensive layers. When solar cell 10 includes the plurality of cell bodies 20, a first portion of the plurality of cell bodies 20 may be configured to absorb a different wavelength, or range of wavelengths, of incident light, than a second portion of the plurality of cell bodies 20, which may increase an overall fraction of incident light that may be absorbed by solar cell 10. When solar cell 10 includes the plurality of cell bodies 20, front side electrical contact 60 may be configured to form the electrical connection with the front side cell body, and back side electrical contact 80 may be configured to form the electrical connection with the back side cell body.

Semiconductor manufacturing techniques in general, and solar cell manufacturing techniques in particular, provide for a wide variety of methods of forming, constructing, or manufacturing, the solar cells that are discussed in more detail herein with reference to Figs. 1-4. This may include at least top-down, bottom-up, and/or lift-off manufacturing techniques. As such, the above-discussed structures are not meant to be restricted to a single method of construction and may be formed in any suitable manner.

With this in mind, and as used herein, the term "situated" is meant to convey that a given element is positioned, located, placed, formed, fabricated, deposited, implanted, and/or grown at a given location. As an illustrative, non-exclusive example, when a first layer is situated between a second layer and a third layer, it is within the scope of the present disclosure that the first layer may be positioned between the second layer and the third layer; located between the second layer and the third layer; placed between the second layer and the third layer; formed between the second layer and the third layer; formed on the second layer, with the third layer being situated on the first layer; formed on the third layer, with the second layer being situated on the first layer; fabricated between the second layer and the third layer; fabricated on the second layer, with the third layer being situated on the first layer; fabricated on the third layer, with the second layer being situated on the first layer; deposited between the second layer and the third layer; deposited on the second layer, with the third layer being situated on the first layer; deposited on the third layer, with the second layer being situated on the first layer; implanted between the second layer and the third layer; implanted in the second layer, with the third layer being situated on the first layer; implanted in the third layer, with the second layer being situated on the first layer; grown between the second layer and the third layer; grown on the second layer, with the third layer being situated on the first layer; and/or grown on the third layer, with the second layer being situated on the first layer. It is also within the scope of the present disclosure that one or more additional layers may be situated between the first layer and the second layer and/or between the first layer and the third layer.

Thus, solar cells 10 that are disclosed in Figs. 1-4 may describe methods of fabricating the given solar cells, wherein the methods include positioning, locating, placing, forming, fabricating, depositing, implanting, and/or growing any suitable layer with respect to any other suitable layer. As an illustrative, non-exclusive example, and with reference to Fig. 1, a method of forming solar cell 10 may include fabricating cell body 20, fabricating front side electrical contact 60, fabricating back side electrical contact 80, and fabricating intermediate layer 100 between cell body 20 and front side electrical contact 60 and/or between cell body 20 and back side electrical contact 80.

Due to the above-discussed manufacturing variations, it is within the scope of the present disclosure that an interface between two layers and/or structures within solar cell 10 may include a variety of structures. As an illustrative, non-exclusive example, and when a first layer is formed in contact with a second layer through an epitaxial growth process, the interface may define a nearly atomically flat surface that shows an almost perfect step change between the composition of the first layer and the composition of the second layer. As another illustrative, non-exclusive example, and when the first layer is formed in contact with the second layer through a diffusion and/or implant process, the interface may define a concentration gradient region between the bulk composition of the first layer and the bulk composition of the second layer. With this in mind, the phrase "side" or "surface," when used herein with reference to a layer and/or structure of solar cell 10, may refer to any suitable delineation between the composition of the first layer, or structure, and the composition of the second layer, or structure and may include a discrete, or at least substantially discrete, interface, as well as a location within the concentration gradient region between the two layers, or structures.

In another embodiment, there is provided a solar cell comprising:
a cell body that includes a front side and an opposed back side;
a front side electrical contact that forms an electrical connection with the front side;
a back side electrical contact that forms an electrical connection with the back side; and
means for forming a low mobile carrier recombination velocity connection between the cell body and at least one of the front side electrical contact and the back side electrical contact.

Optionally, the means for forming includes an intermediate layer that is situated between the cell body and at least one of the front side electrical contact and the back side electrical contact.

In another embodiment, there is provided a solar cell comprising:
a cell body that includes a front side and an opposed back side;
a front side electrical contact that forms an electrical connection with the front side;
a back side electrical contact that forms an electrical connection with the back side; and
an intermediate layer that is situated between the cell body and at least one of the front side electrical contact and the back side electrical contact.

Optionally, the intermediate layer includes an at least substantially planar, and optionally a planar, intermediate layer.

Optionally, the intermediate layer includes, and optionally is, an electrically insulating layer.

Optionally, the electrically insulating layer includes a deposited insulating layer, and optionally wherein the deposited insulating layer includes a deposited oxide layer.

Optionally, the electrically insulating layer includes at least one of an oxide, aluminum oxide, silicon nitride, silicon oxide, silicon dioxide, zinc sulfide, hafnium oxide, and silicon oxynitride.

Optionally, the electrically insulating layer includes at least one of a native oxide layer and a grown oxide layer.

Optionally, the electrically insulating layer has a thickness of at least 0.1 nanometers (nm), at least 0.2 nm, at least 0.25 nm, at least 0.3 nm, at least 0.4 nm, at least 0.5 nm, at least 0.6 nm, at least 0.7 nm, at least 0.75 nm, at least 0.8 nm, at least 0.9 nm, at least 1 nm, at least 1.1 nm, at least 1.2 nm, at least 1.25 nm, at least 1.3 nm, at least 1.4 nm, at least 1.5 nm, at least 1.6 nm, at least 1.7 nm, at least 1.75 nm, at least 1.8 nm, at least 1.9 nm, at least 2 nm, at least 2.25 nm, at least 2.5 nm, at least 3 nm, at least 3.5 nm, at least 4 nm, at least 4.5 nm, at least 5 nm, or at least 5.5 nm and/or a thickness of less than 15 nm, less than 14 nm, less than 13 nm, less than 12 nm, less than 11 nm, less than 10 nm, less than 9 nm, less than 8 nm, less than 7.5 nm, less than 7 nm, less than 6.5 nm, less than 6 nm, less than 5.5 nm, less than 5 nm, less than 4.5 nm, less than 4 nm, less than 3.5 nm, or less than 3 nm.

Optionally, an electrical resistivity of the electrically insulating layer is greater than 10⁴ Ohm*cm, greater than 10⁵ Ohm*cm, greater than 10⁶ Ohm*cm, greater than 10⁷ Ohm*cm, greater than 10⁸ Ohm*cm, greater than 10⁹ Ohm*cm, greater than 10¹⁰ Ohm*cm, greater than 10¹¹ Ohm*cm, greater than 10¹² Ohm*cm, greater than 10¹³ Ohm*cm, greater than 10¹⁴ Ohm*cm, greater than 10¹⁵ Ohm*cm, greater than 10¹⁶ Ohm*cm, greater than 10¹⁷ Ohm*cm, or greater than 10¹⁸ Ohm*cm.

Optionally, the electrically insulating layer is a planar, or at least substantially planar, electrically insulating layer that is coextensive with all, or at least substantially all, of at least one of the front side of the cell body and the back side of the cell body.

Optionally, the electrically insulating layer is a planar, or at least substantially planar, electrically insulating layer that is present between the front side electrical contact and the cell body, and optionally wherein the electrically insulating layer is not present on a portion of the front side of the cell body that does not include the front side electrical contact.

Optionally, the intermediate layer includes, and optionally is, a surface passivation layer.

Optionally, the surface passivation layer is configured to reduce a mobile carrier recombination velocity at a surface of the cell body, optionally wherein the surface of the cell body includes at least one of the front side and the back side, and further optionally wherein the surface of the cell body includes a surface of the cell body that at least one of is in contact with and forms a portion of the surface passivation layer.

Optionally, the surface passivation layer is configured to reduce a concentration of at least one of broken bonds and recombination sites on, and optionally proximal to, a/the surface of the cell body that at least one of is in contact with and forms a portion of the surface passivation layer.

Optionally, the surface passivation layer has a thickness of less than 5 nm, less than 4 nm, less than 3 nm, less than 2 nm, less than 1 nm, less than 0.8 nm, less than 0.6 nm, less than 0.5 nm, less than 0.4 nm, less than 0.3 nm, less than 0.2 nm, or less than 0.1 nm.

Optionally, the surface passivation layer includes a/the surface of the cell body that has experienced a surface passivation treatment.

Optionally, the surface passivation layer includes, and optionally is, a dielectric layer.

Optionally, the intermediate layer includes the surface passivation layer and an/the electrically insulating layer, optionally wherein the surface passivation layer and the electrically insulating layer define parallel layers, optionally wherein the surface passivation layer and the electrically insulating layer define substantially planar layers, and further optionally wherein the surface passivation layer is situated between the cell body and the electrically insulating layer.

Optionally, the surface passivation layer is a planar, or at least substantially planar, surface passivation layer that is coextensive with all, or at least substantially all, of at least one of the front side of the cell body and the back side of the cell body.

Optionally, the intermediate layer is a front side intermediate layer that is situated between the cell body and the front side electrical contact.

Optionally, the intermediate layer is a back side intermediate layer that is situated between the cell body and the back side electrical contact.

Optionally, the solar cell includes a plurality of intermediate layers including the front side intermediate layer described hereinabove and the back side intermediate layer described hereinabove.

Optionally, the front side electrical contact is deposited on and is in electrical communication with the front side of the cell body.

Optionally, the front side electrical contact includes a metallic front side electrode, and optionally wherein the metallic front side electrode includes at least one of nickel germanium gold, palladium germanium gold, copper, and aluminum.

Optionally, the front side electrical contact further includes a front side cap layer that is situated between the metallic front side electrode and the cell body, optionally wherein the front side cap layer is configured to decrease diffusion of the metallic front side electrode into the cell body, and further optionally wherein the front side cap layer is situated between a/the front side intermediate layer and the cell body.

Optionally, the front side electrical contact includes an optically transparent front side electrode, and optionally wherein the optically transparent front side electrode includes at least one of indium tin oxide, zinc oxide, tin oxide, zinc selenide, graphene, carbon nanotubes, gallium nitride, and diamond.

Optionally, the front side electrical contact includes both a/the metallic front side electrode and a/the optically transparent front side electrode, optionally wherein the optically transparent front side electrode is situated between the metallic front side electrode and the cell body, optionally wherein the metallic front side electrode includes a plurality of front side metallic lines, and further optionally wherein a spacing between a selected one of the plurality of front side metallic lines and an adjoining one of the plurality of front side metallic lines is greater than a spacing in a comparable solar cell that includes the metallic front side electrode but does not include the optically transparent front side electrode.

Optionally, the back side electrical contact is deposited on and is in electrical communication with the back side of the cell body.

Optionally, the back side electrical contact includes a metallic back side electrode, and optionally wherein the metallic back side electrode includes at least one of copper and aluminum.

Optionally, the back side electrical contact further includes a back side insulator that is situated between a portion of the metallic back side electrode and the cell body.

Optionally, the back side electrical contact further includes a back side cap layer that is situated between the metallic back side electrode and the cell body, optionally wherein the back side cap layer is configured to decrease diffusion of the metallic back side electrode into the cell body, and further optionally wherein the back side cap layer is situated between a/the back side intermediate layer and the cell body.

Optionally, the back side electrical contact includes an optically transparent back side electrode, and optionally wherein the optically transparent back side electrode includes at least one of indium tin oxide, zinc oxide, tin oxide, zinc selenide, graphene, carbon nanotubes, gallium nitride, and diamond.

Optionally, the back side electrical contact includes both a/the metallic back side electrode and a/the optically transparent back side electrode.

Optionally, the optically transparent back side electrode is situated between the metallic back side electrode and the cell body.

Optionally, the metallic back side electrode includes a plurality of back side metallic lines, and optionally wherein a spacing between a selected one of the plurality of back side metallic lines and an adjoining one of the plurality of back side metallic lines is greater than a spacing in a comparable solar cell that includes the metallic back side electrode but does not include the optically transparent back side electrode.

Optionally, the metallic back side electrode and the optically transparent back side electrode define parallel and/or substantially planar electrode layers.

Optionally, the cell body includes a substantially planar, and optionally a planar, cell body.

Optionally, the solar cell includes an antireflective layer, optionally wherein the antireflective layer defines the front side of the cell body, and further optionally wherein the antireflective layer defines at least a portion of an exposed front side of the solar cell.

Optionally, the antireflective layer includes at least one of a planar antireflective layer and a substantially planar antireflective layer.

Optionally, the antireflective layer includes a dielectric antireflective layer, and optionally wherein the antireflective layer includes a plurality of openings that are configured to provide for the electrical connection between the front side electrical contact and the cell body.

Optionally, the cell body includes a window layer.

Optionally, the window layer is situated between an/the antireflective layer and an/the emitter layer.

Optionally, a/the intermediate layer is situated between the window layer and the antireflective layer, optionally wherein the intermediate layer is formed on the window layer, and further optionally wherein the antireflective layer is formed on the intermediate layer.

Optionally, the window layer includes a wide band gap semiconductor material.

Optionally, the window layer is at least substantially optically transparent.

Optionally, the window layer includes a window layer thickness, optionally wherein the window layer thickness is less than 500 Angstroms (Å), less than 450 Å, less than 400 Å, less than 350 Å, less than 300 Å, less than 250 Å, less than 200 Å, less than 150 Å, less than 100 Å, less than 75 Å, less than 50 Å, or less than 25 Å, and further optionally wherein the window layer thickness is greater than greater than 10 Å, greater than 20 Å, greater than 30 Å, greater than 40 Å, greater than 50 Å, greater than 75 Å, greater than 100 Å, greater than 125 Å, greater than 150 Å, greater than 175 Å, or greater than 200 Å.

Optionally, the window layer includes a semiconductor material of a first conductivity type.

Optionally, the cell body, and optionally the solar cell, does not include a window layer.

Optionally, the cell body includes an/the emitter layer.

Optionally, the emitter layer is between a/the window layer and a base layer.

Optionally, the window layer is at least one of in contact with, deposited on, and formed in the emitter layer.

Optionally, the emitter layer is between a/the antireflective layer and a/the base layer.

Optionally, the emitter layer is at least one of in contact with, deposited on, and formed in the base layer.

Optionally, an/the intermediate layer is situated between the emitter layer and an/the antireflective layer, optionally wherein the antireflective layer is formed on the intermediate layer, optionally wherein the intermediate layer is formed on the emitter layer, optionally wherein the emitter layer is formed on a/the base layer, and further optionally wherein the solar cell does not include a window layer.

Optionally, the emitter layer includes a/the semiconductor material of a/the first conductivity type.

Optionally, the solar cell includes an emitter layer, and further wherein the emitter layer forms a portion of the front side electrical contact.

Optionally, an/the intermediate layer is situated between the emitter layer and at least one of the cell body and a/the base layer of the cell body.

Optionally, the emitter layer is at least one of in contact with and deposited on the intermediate layer.

Optionally, the intermediate layer is at least one of in contact with, deposited on, and formed in at least one of the cell body and a/the base layer of the cell body.

Optionally, the cell body further includes a/the base layer.

Optionally, the base layer includes a semiconductor material of a second conductivity type.

Optionally, the base layer is situated between a/the emitter layer and a/the back surface field layer.

Optionally, an/the emitter layer is at least one of in contact with, deposited on, and formed in the base layer.

Optionally, the intermediate layer is situated between the emitter layer and the base layer.

Optionally, the intermediate layer is at least one of in contact with, formed on, and formed in the base layer.

Optionally, the emitter layer is at least one of in contact with and formed on the intermediate layer.

Optionally, the base layer includes at least one textured side, optionally wherein the at least one textured side includes a root mean square roughness of at least 0.1 micrometer (um), at least 0.2 um, at least 0.3 um, at least 0.4 um, at least 0.5 um, at least 0.75 um, at least 1 um, at least 1.25 um, at least 1.5 um, or at least 2 um, optionally wherein the at least one textured side includes a root means square roughness of less than 3 um, less than 2.5 um, less than 2 um, less than 1.5 um, less than 1.25 um, or less than 1 um, and further optionally wherein the at least one textured side includes at least one, and optionally both, of a front side of the base layer and a back side of the base layer.

Optionally, the base layer includes at least one polished side, optionally wherein the at least one polished side includes a root mean square roughness of less than 100 nanometers (nm), less than 75 nm, less than 50 nm, less than 40 nm, less than 30 nm, less than 20 nm, less than 10 nm, less than 5 nm, less than 4 nm, less than 3 nm, less than 2 nm, or less than 1 nm, and further optionally wherein the at least one polished side includes at least one, and optionally both, of a/the front side of the base layer and a/the back side of the base layer.

Optionally, the cell body includes a back surface field layer.

Optionally, the back surface field layer includes a/the semiconductor material of a/the second conductivity type, and optionally wherein a/the mobile carrier concentration in the back surface field layer is greater than a/the mobile carrier concentration in a/the base layer of the cell body.

Optionally, the back surface field layer is situated between a/the base layer and the back side electrical contact.

Optionally, the back surface field layer is at least one of in contact with the base layer, formed on the base layer, and formed in the base layer.

Optionally, the solar cell includes a plurality of cell bodies, wherein the plurality of cell bodies includes at least a front side cell body and a back side cell body, and further wherein the plurality of cell bodies are arranged on top of and in electrical communication with one another in a plurality of coextensive layers.

Optionally, a first portion of the plurality of cell bodies is configured to absorb a different wavelength, or range of wavelengths, of electromagnetic radiation than a second portion of the plurality of cell bodies.

Optionally, the front side electrical contact is configured to form the electrical connection with the front side cell body, and further wherein the back side electrical contact is configured to form the electrical connection with the back side cell body.

Optionally, the front side of the cell body is configured to be a light-incident side of the cell body.

Optionally, the cell body includes:
a base layer, wherein the base layer includes a semiconductor material of a second conductivity type, and further wherein the base layer is situated closer to the front side of the cell body than to the back side of the cell body; and
a back surface field layer, wherein the back surface field layer includes the semiconductor material of the second conductivity type, and further wherein the back surface field layer is situated between the base layer and the back side of the cell body.

Optionally, the back surface field layer is at least one of in contact with, formed on, and formed in the base layer.

Optionally, a mobile carrier concentration in the back surface field layer is greater than a mobile carrier concentration in the base layer.

Optionally, the solar cell further includes an antireflective layer, wherein the base layer is situated between the antireflective layer and the back surface field layer.

Optionally, the intermediate layer is a front side intermediate layer that is situated between the front side electrical contact and the cell body.

Optionally, the front side intermediate layer includes a surface passivation layer and an electrically insulating layer, and further wherein the surface passivation layer is situated between the electrically insulating layer and the cell body.

Optionally, the front side electrical contact includes an optically transparent front side electrode.

Optionally, the optically transparent front side electrode defines an emitter layer of the solar cell.

Optionally, the cell body further includes an emitter layer, wherein the emitter layer includes a semiconductor material of a first conductivity type, and further wherein the emitter layer is situated between the front side intermediate layer and the base layer.

Optionally, the emitter layer is at least one of in contact with, formed on, and formed in the base layer.

Optionally, the cell body further includes a window layer, wherein the window layer includes the semiconductor material of the first conductivity type, and further wherein the window layer is situated between the emitter layer and the front side intermediate layer.

Optionally, the window layer is between an/the antireflective layer and the emitter layer.

Optionally, the antireflective layer includes a plurality of openings that are configured to provide for the electrical connection between the front side electrical contact and the cell body, wherein the front side electrical contact includes a metallic front side electrode, and further wherein the front side electrical contact includes a front side cap layer that is situated between the metallic front side electrode and the cell body, wherein the front side cap layer is configured to decrease diffusion of the metallic front side electrode into the cell body.

Optionally, the front side electrical contact includes a metallic front side electrode, wherein the solar cell does not include a window layer between the front side electrical contact and the emitter layer, and optionally wherein the solar cell does not include a front side cap layer between the front side electrical contact and the emitter layer.

Optionally, the electrically insulating layer is situated between the metallic front side electrode and the emitter but is not located on a portion of the emitter that does not include a substantially opposed metallic front side electrode.

Optionally, the electrically insulting layer covers substantially all, and optionally all, of the emitter layer.

Optionally, the intermediate layer is a back side intermediate layer that is situated between the back side electrical contact and the cell body, optionally wherein the solar cell includes a plurality of intermediate layers, and further optionally wherein the solar cell includes the back side intermediate layer and a/the front side intermediate layer.

Optionally, the back side intermediate layer includes a surface passivation layer and an electrically insulating layer, and further wherein the surface passivation layer is situated between the electrically insulating layer and the cell body.

Optionally, the back side electrical contact includes a metallic back side electrode, and optionally wherein the metallic back side electrode includes at least one of a planar metallic back side electrode and a substantially planar metallic back side electrode.

Optionally, the metallic back side electrode covers substantially all, and optionally all, of the back side of the cell body.

Optionally, the back side electrical contact further includes a back side cap layer that is situated between the metallic back side electrode and the back side intermediate layer.

Optionally, the back side electrical contact includes an optically transparent back side electrode, and optionally wherein the optically transparent back side electrode includes at least one of an optically transparent planar back side electrode and an optically transparent substantially planar back side electrode.

Optionally, the optically transparent back side electrode covers substantially all, and optionally all, of the back side of the cell body.

Optionally, the back side electrical contact further includes a metallic back side electrode, and further wherein the optically transparent back side electrode is situated between the metallic back side electrode and the back side intermediate layer.

Optionally, the metallic back side electrode covers substantially all, and optionally all, of the back side of the cell body.

Optionally, the solar cell of any of paragraphs from page 27, line 29 to page 30, line 5 can be combined in combination with any of the features of the solar cell of any of paragraphs from page 21, line 1 to page 27, line 28.

Optionally, at least a portion of the cell body is formed from a/the semiconductor material.

Optionally, the semiconductor material includes a/the semiconductor material of a/the first conductivity type and a/the semiconductor material of a/the second conductivity type.

Optionally, the first conductivity type includes one of n-type and p-type, and further wherein the second conductivity type includes the other of n-type and p-type.

Optionally, the semiconductor material includes at least one of a III-V semiconductor material, gallium arsenide, aluminum gallium arsenide, indium gallium phosphide, germanium, indium gallium arsenide nitride, indium phosphide, indium gallium arsenide, and silicon.

In another embodiment, there is provided a method of forming a low mobile carrier recombination velocity electrical contact in a solar cell, the method comprising:
fabricating a cell body, wherein the cell body includes at least a base layer that includes a semiconductor material of a second conductivity type and an emitter layer that includes a semiconductor material of a first conductivity type, and further wherein the cell body defines a front side and an opposed back side;
fabricating a front side electrical contact that forms an electrical connection with the front side;
fabricating a back side electrical contact that forms an electrical connection with the back side; and
fabricating an intermediate layer that includes at least an electrically insulating layer between at least one of:
   (1) the front side electrical contact and the cell body; and
   (2) the back side electrical contact and the cell body.

Optionally, the intermediate layer further includes a surface passivation layer.

Optionally, the solar cell includes any solar cell of any described hereinabove.

In another embodiment, there is provided the use of any of the solar cells described hereinabove with any of the methods described hereinabove.

In another embodiment, there is provided the use of any of the methods described hereinabove with any of the solar cells described hereinabove.

Optionally, the use of an intermediate layer includes at least an electrically insulating layer to decrease a mobile carrier recombination velocity of mobile carriers in a solar cell.

As used herein, the terms "selective" and "selectively," when modifying an action, movement, configuration, or other activity of one or more components or characteristics of an apparatus, mean that the specific action, movement, configuration, or other activity is a direct or indirect result of user manipulation of an aspect of, or one or more components of, the apparatus.

As used herein, the terms "adapted" and "configured" mean that the element, component, or other subject matter is designed and/or intended to perform a given function. Thus, the use of the terms "adapted" and "configured" should not be construed to mean that a given element, component, or other subject matter is simply "capable of' performing a given function but that the element, component, and/or other subject matter is specifically selected, created, implemented, utilized, programmed, and/or designed for the purpose of performing the function. It is also within the scope of the present disclosure that elements, components, and/or other recited subject matter that is recited as being adapted to perform a particular function may additionally or alternatively be described as being configured to perform that function, and vice versa.

The various disclosed elements of apparatuses and steps of methods disclosed herein are not required to all apparatuses and methods according to the present disclosure, and the present disclosure includes all novel and non-obvious combinations and subcombinations of the various elements and steps disclosed herein. Moreover, one or more of the various elements and steps disclosed herein may define independent inventive subject matter that is separate and apart from the whole of a disclosed apparatus or method. Accordingly, such inventive subject matter is not required to be associated with the specific apparatuses and methods that are expressly disclosed herein, and such inventive subject matter may find utility in apparatuses and/or methods that are not expressly disclosed herein.

## Claims

1. A solar cell comprising:
a cell body 20 that defines a front side 14 and an opposed back side 18, wherein the cell body 20 is formed from a semiconductor material;
a front side electrical contact 60 that forms an electrical connection with the front side of the cell body 14;
a back side electrical contact 80 that forms an electrical connection with the back side of the cell body 28; and
an intermediate layer 100 that is situated between the cell body 20 and at least one of the front side electrical contact 60 and the back side electrical contact 80, wherein the intermediate layer 100 includes an electrically insulating layer, and further wherein the electrically insulating layer 110 includes a deposited electrically insulating layer.

2. The solar cell of claim 1, wherein the cell body 20 includes an emitter layer 40 that includes one of an n-type III-V semiconductor material and a p-type III-V semiconductor material, wherein the cell body 20 further includes a base layer 48 that includes the other of the n-type III-V semiconductor material and the p-type III-V semiconductor material, and further wherein the base layer 48 is situated between the emitter layer 40 and the back side of the cell body.

3. The solar cell of claim 1 or 2, wherein the solar cell further includes an emitter layer, wherein the emitter layer forms a portion of the front side electrical contact 60, and further wherein the cell body 20 further includes a base layer.

4. The solar cell of claim 1, wherein the electrically insulating layer 110 includes at least one of an oxide, aluminum oxide, silicon nitride, silicon oxide, silicon dioxide, zinc sulfide, hafnium oxide, and silicon oxynitride.

5. The solar cell of claim 1, wherein the electrically insulating layer 110 has a thickness of at least 1 nm and less than 6 nm.

6. The solar cell of claim 1, wherein the intermediate layer 100 further includes a surface passivation layer 120 that is configured to reduce a mobile carrier recombination velocity at a surface of the cell body.

7. The solar cell of claim 6, wherein the surface passivation layer 120 has a thickness of less than 2 nm.

8. The solar cell of claim 1, wherein the intermediate layer 100 is a front side intermediate layer 101 that is situated between the cell body 20 and the front side electrical contact 60.

9. The solar cell of claim 1, wherein the intermediate layer 100 is a back side intermediate layer 102 that is situated between the cell body 20 and the back side electrical contact 80.

10. The solar cell of any of claims 1-9, wherein the solar cell includes a plurality of intermediate layers 100 including a front side intermediate layer 100 that is situated between the cell body and the front side electrical contact 60 and a back side intermediate layer 102 that is situated between the cell body 20 and the back side electrical contact 80.

11. The solar cell of claim 1, wherein the front side electrical contact 60 is deposited on and is in electrical communication with at least one of the front side 24 of the cell body 20 and the intermediate layer 100.

12. The solar cell of claim 11, wherein the front side electrical contact 60 includes a metallic front side electrode 64 or an optically transparent front side electrode 68.

13. The solar cell of claim 1, wherein the back side electrical contact 80 is deposited on and is in electrical communication with at least one of the back side 28 of the cell body 20 and the intermediate layer 100.

14. The solar cell of claim 13, wherein the back side electrical contact 80 includes a metallic back side electrode 84 or an optically transparent back side electrode 88.

15. The solar cell of claim 1, wherein the front side of the cell body 20 is a light-incident side of the cell body 20.
